(19) Europäisches Patentamt
European Patent Office
Office européen des brevets

(11) **EP 4 629 809 A2**

(12) **EUROPEAN PATENT APPLICATION**

(43) Date of publication:
**08.10.2025 Bulletin 2025/41**

(21) Application number: 25182401.7

(22) Date of filing: **28.05.2018**

(51) International Patent Classification (IPC):
**H10K 85/50** (2023.01)   **H10K 30/57** (2023.01)
**H10F 10/19** (2025.01)   **H10F 77/70** (2025.01)

(52) Cooperative Patent Classification (CPC):
**H10F 10/19; H10F 77/703; H10K 30/57;**
**H10K 85/50;** H10K 30/151; H10K 30/50;
Y02E 10/542; Y02E 10/549; Y02P 70/50

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **29.05.2017   KR 20170066437**

(62) Document number(s) of the earlier application(s) in
accordance with Art. 76 EPC:
**18810525.8 / 3 633 736**

(71) Applicant: **JingAo Solar Co., Ltd.**
**Xingtai City, Hebei Province (CN)**

(72) Inventors:
• **LEE, Yu Jin**
**06772 Seoul (KR)**
• **KIM, Seongtak**
**06772 Seoul (KR)**
• **AHN, Seh-Won**
**06772 Seoul (KR)**
• **CHUNG, Jin-Won**
**06772 Seoul (KR)**

(74) Representative: **Lucke, Andreas**
**Boehmert & Boehmert**
**Anwaltspartnerschaft mbB**
**Pettenkoferstrasse 22**
**80336 München (DE)**

Remarks:
This application was filed on 12.06.2025 as a
divisional application to the application mentioned
under INID code 62.

(54) **PEROVSKITE SILICON TANDEM SOLAR CELL AND MANUFACTURING METHOD THEREOF**

(57)    A tandem solar cell comprises a substrate on which a rounded texture is formed, and a perovskite absorption layer formed on the substrate. The rounded texture comprises peak portions, and valley portions of the rounded texture are planarized.

FIG. 6

## Description

## BACKGROUND

Technical Field

The present disclosure relates to a tandem solar cell, and more particularly, to a monolithic tandem solar cell in which a perovskite solar cell is uniformly stacked on and bonded to a textured silicon solar cell and a method of manufacturing the same.

Description of the Related Art

Crystalline silicon (c-Si) solar cells are representative single-junction solar cells which are currently widely used as commercial solar cells. However, due to the low photoelectric conversion efficiency of crystalline silicon solar cells, the development of a tandem solar cell which is constructed by connecting two single-junction solar cells having absorption layers of different band gaps is actively ongoing.

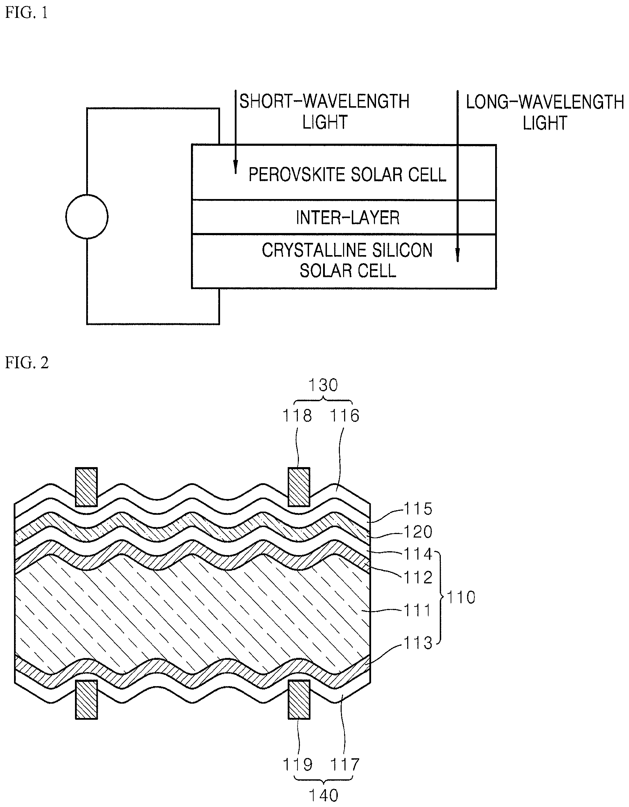

FIG. 1 is a schematic cross-sectional view of a two-terminal tandem solar cell, which is a common type of tandem solar cell.

Referring to FIG. 1, in the solar cell, a single-junction solar cell including an absorption layer having a relatively large band gap and a single-junction solar cell including an absorption layer having a relatively small band gap are tunnel-junctioned through a inter-layer.

Perovskite/crystalline silicon tandem solar cells have been attracting attention as potential candidates for achieving a photovoltaic efficiency of more than 30%, where a single junction solar cell including an absorption layer having a relatively large bandgap among various types of two-terminal tandem solar cells is used as a perovskite solar cell and a single junction solar cell including an absorption layer having a relatively small bandgap is used as a crystalline silicon solar cell.

In a perovskite/crystalline silicon tandem solar cell, a textured structure having both valley shapes and peak shapes is formed on a crystalline silicon substrate surface in order to reduce the reflectance of incident light and thereby improve light efficiency.

A perovskite absorption layer subsequently formed on the silicon substrate is formed using a thin-film process such as a liquid solution process, a chemical deposition process, or a physical deposition process.

The texture has a geometrically fine pitch in that the distance between peaks is several micrometers to several tens of micrometers.

If the process of forming a perovskite absorption layer uses a solution which is a material having relatively high fluidity, it is difficult to fill valley portions with the perovskite absorption layer material due to a viscous nature of the solution, and as a result, the optical characteristics of the solar cell are degraded.

Meanwhile, when a subsequent process is a thin-film process, in order to form a porous perovskite absorption layer, before particles that have reached the substrate are stacked in stable valley positions, it is required that other subsequent particles reach and become deposited on the textured substrate.

Therefore, regardless of whether a perovskite absorption layer is deposited at one time or in two steps, the fine pitch of the texture makes the uniform crystallization conversion of the perovskite absorption layer difficult.

Moreover, when the substrate is made of silicon, an inclined surface of the texture forms a geometric inclination angle of about 55 degrees relative to the horizontal direction of the {100} substrate due to the chemical stability of a {111}plane.

Such a large inclination angle impedes the formation of a perovskite absorption layer at the inclined portions, and as a result, the thickness of the perovskite absorption layer may become non-uniform in that the thickness becomes smaller at peaks and inclined portions than near valleys.

## SUMMARY

The present disclosure is directed to providing a tandem solar cell including a substrate on which a texture having both valley shapes and peak shapes is formed in order to reduce the reflectance of vertically incident light as well as obliquely changing the direction of light incidence, wherein the valley and peak portions of the texture have a round shape due to a rounding process.

In addition, the present disclosure is directed to improving, by increasing the radii of curvature of a texture of a substrate, the uniformity of a inter-layer (also referred to as a tunnel inter-layer or an intermediate layer) and a perovskite absorption layer that are formed on the texture. In other words, a tandem solar cell may comprise a substrate on which a texture having valley shapes and peak shapes is formed; and a perovskite absorption layer formed on the substrate, wherein valley portions and peak portions of the texture have a round shape.

According to an embodiment of the present disclosure for forming a uniform perovskite absorption layer provides a tandem solar cell which includes: a substrate on which a texture having valley and peak shapes is formed; and a perovskite absorption layer formed on the substrate, wherein the valley portions and the peak portions of the texture have a round shape.

There may be provided a tandem solar cell in which the radii of curvature of the valley portions are different from the radii of curvature of the peak portions. In other words, a radius of curvature of the valley portion may have a different value from a radius of curvature of the peak portion.

There may be provided a tandem solar cell in which absolute values of the radii of curvature of the valley portions are greater than or equal to absolute values of the radii of curvature of the peak portions. In other words, an absolute value of the radius of curvature of the valley portion may be greater than or equal to an absolute value of the radius of curvature of the peak portion.

There may be provided a tandem solar cell in which the radii of curvature of the valley portions are in a range of 0.05 to 50 $\mu$m. In other words, the radius of curvature of the valley portion may be in a range of 0.05 $\mu$m to 50 $\mu$m.

There may be provided a tandem solar cell in which inclined surfaces connecting valley portions to peak portions form an angle of less than 55 degrees relative to the planar direction of the substrate. In other words, an inclined surface connecting the valley portion to the peak portion may form an angle of less than 55 degrees relative to a planar direction of the substrate.

There may be provided a tandem solar cell in which, in the texture, an average distance between valleys or between centers of flat portions is larger than an average distance between peaks.

There may be provided a tandem solar cell in which a thickness of the perovskite absorption layer formed at the valley portions of a texture differs from thicknesses at the peak portions and the inclined surfaces of the texture by at most 10%. In other words, a thickness of the perovskite absorption layer formed at the valley portion of the texture may differ from thicknesses at the peak portion and the inclined surface thereof by at most 10%.

According to another embodiment of the present disclosure provides a method of manufacturing a tandem solar cell that includes: forming a texture having valley and peak shapes on a substrate; performing a rounding process on valley and peak portions of the texture; and forming a perovskite absorption layer on the substrate. In other words, a method of manufacturing a tandem solar cell may comprise: forming a texture having valley shapes and peak shapes on a substrate; performing a rounding process on valley portions and peak portions of the texture; and forming a perovskite absorption layer on the substrate.

The texture may be formed by anisotropic etching. In other words, there may be provided a method of manufacturing a tandem solar cell in which the forming of the texture on the substrate is carried out by anisotropic etching.

There may be provided a method of manufacturing a tandem solar cell in which the rounding process is isotropic etching that is carried out by any one of wet etching, sputtering etching, reactive ion etching, and vapor-phase etching. In particular, the rounding process may be etching carried out using an etching solution in which hydrofluoric acid and nitric acid are mixed in a ratio of 1:(10 to 80).

There may be provided a method of manufacturing a tandem solar cell in which the rounding process is etching carried out using an etching solution in which hydrofluoric acid and nitric acid are mixed in a ratio of 1:(10 to 80).

There may be provided a method of manufacturing a tandem solar cell which may further include forming a inter-layer before the forming of the perovskite absorption layer.

There may be provided a method of manufacturing a tandem solar cell in which the perovskite absorption layer is formed by physical vapor deposition or chemical vapor deposition.

There may be provided a method of manufacturing a tandem solar cell in which the perovskite absorption layer is formed through a porous precursor layer.

According to the present disclosure, there can be provided a tandem solar cell in which the valley and peak portions of a texture are rounded and a method of manufacturing the same.

Since the present disclosure allows a perovskite absorption layer to be uniformly formed and converted at valley portions of a texture, there are effects of not only uniformly improving tandem solar cell efficiency throughout a panel but also stably forming a inter-layer at peak portions.

In addition, in the present disclosure, isotropic etching prevents etching from being localized to peak portions which preferentially react with an etching composition as well as promoting etching towards valley portions. The isotropic etching of the present disclosure can form a texture in which the absolute values of the radii of curvature of the valley portions are greater than or equal to the absolute values of the radii of curvature of the peak portions. Since the isotropic etching method of the present disclosure allows a perovskite absorption layer to be stably converted at valley portions while maintaining the frame of the texture intact, the light absorption and the reliability of a tandem solar cell can be improved.

In addition, in the etching method of the present disclosure, the inclination angle of the inclined surfaces connecting valley portions to peak portions is reduced through rounding. Since a difference in the thickness of a perovskite absorption layer formed on the texture at the valley portions, the peak portions, and the inclined portions can thus be reduced by the etching method of the present disclosure, tandem solar cell efficiency can be uniformly improved throughout a panel.

**BRIEF DESCRIPTION OF THE DRAWINGS**

- FIG. 1 is a schematic view for schematically illustrating a common tandem solar cell.
- FIG. 2 is a cross-sectional view of a tandem solar cell according to one embodiment of the present disclosure.
- FIG. 3 is a detailed cross-sectional view of the perovskite solar cell of FIG. 2.
- FIG. 4 is a cross-sectional electron microscope image illustrating a substrate on which a texture having peak portions and valley portions is formed.

* FIG. 5 shows (a) a cross-sectional electron microscope image of a substrate having a texture including peak and valley portions on which a rounding process is performed, (b) an enlarged view of a valley portion, and (c) an enlarged view of valley portions and peak portions.
* FIG. 6 is a cross-sectional electron microscope image of a substrate having a rounded texture according to another embodiment.
* FIGS. 7 to 13 are cross-sectional views illustrating the processes of a method of manufacturing a tandem solar cell according to one embodiment of the present disclosure.

## DETAILED DESCRIPTION OF EXEMPLARY EMBODIMENTS

Hereinafter, a tandem solar cell and a method of manufacturing the same according to exemplary embodiments of the present disclosure will be described in detail with reference to the accompanying drawings.

However, the present disclosure is not limited to embodiments described below and may be implemented in a variety of different forms, and the embodiments are only provided to complete the disclosure of the invention and to fully inform the scope of the invention to those skilled in the art.

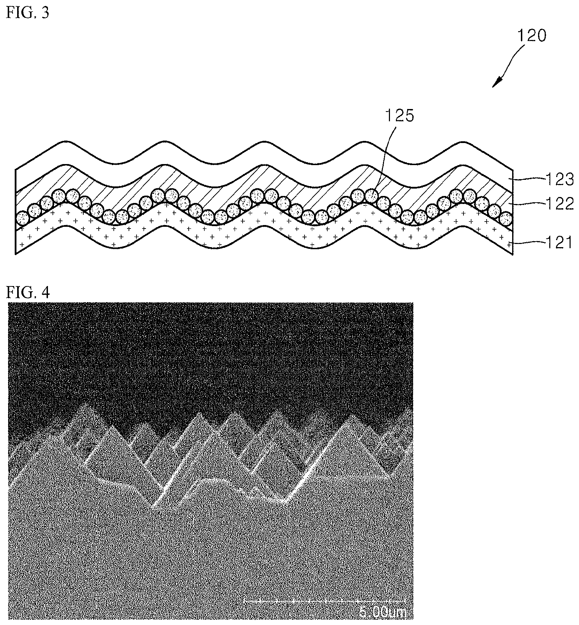

FIG. 2 is a cross-sectional view of a tandem solar cell according to one embodiment of the present disclosure, and FIG. 3 is a detailed cross-sectional view of a perovskite solar cell which is the second solar cell of FIG. 2.

Referring to FIGS. 2 and 3, a tandem solar cell according to a first embodiment of the present disclosure has a structure of a two-terminal tandem solar cell in which a perovskite solar cell 120, as a second solar cell including an absorption layer having a relatively large band gap, and a silicon solar cell 110, as a first solar cell including an absorption layer having a relatively small band gap, are directly tunnel-junctioned through a inter-layer 114.

Accordingly, among light incident on the tandem solar cell, light in a short-wavelength region is absorbed by the perovskite solar cell 120 which is the second solar cell disposed in an upper portion, whereby electrical charges are generated, and light in a long-wavelength region is transmitted through the second solar cell 120 and absorbed by the silicon solar cell 110 which is the first solar cell disposed in a lower portion, whereby electrical charges are generated.

Since the second solar cell 120 disposed in the upper portion is capable of generating electricity by absorbing light in a short-wavelength region and the first solar cell 110 disposed in the lower portion is capable of generating electricity by absorbing light in a long-wavelength region, the threshold wavelength can be shifted toward longer wavelengths, and therefore, the tandem solar cell having the above-described structure has the advantage that the range of wavelengths absorbed by the entire solar cell can be broadened.

The above-described tandem solar cell according to one embodiment of the present disclosure includes a silicon solar cell 110 as a first solar cell, a perovskite solar cell 120 as a second solar cell, a inter-layer 114, a first electrode 140, and a second electrode 130.

The first solar cell 110 of the present disclosure may be implemented as a heterojunction silicon solar cell or homojunction silicon solar cell.

First, when the first solar cell 110 is a heterojunction silicon solar cell, the first solar cell 110 may have a structure in which very thin amorphous intrinsic silicon (i a-Si:H) as a passivation layer is first formed on the front and rear sides of an n-type crystalline silicon substrate, a p-type high-concentration amorphous silicon (p a-Si:H) layer as an emitter layer 112 is formed on a second surface which is on the front side, and, on a first surface which is the rear side, a high-concentration amorphous silicon (n+ a-Si:H) layer as a back surface field (hereinafter abbreviated as BSF) layer 113 is formed.

An amorphous silicon layer has an advantage of being a material which not only has an energy band gap of about 0.6 to 0.7 eV larger than an energy band gap of a crystalline silicon layer which is about 1.1 eV, but also can be formed with a very small thickness during a deposition process. Due to the advantageous features of the amorphous silicon layer, as light absorption loss in a short-wavelength region is minimized, a light utilization rate can be ultimately increased, and a high open-circuit voltage and an effective back surface field can be attained.

Generally, for heterojunctions having a difference in band gaps, there is a very high possibility that lattice mismatch may occur between different materials. However, when an amorphous silicon layer is used, the lattice mismatch does not occur because an amorphous material lacks regularity in a crystal lattice unlike a crystalline material. Therefore, when an intrinsic amorphous silicon (i a-Si) layer is deposited on a crystalline silicon substrate, there is an advantage that a recombination at a surface of a silicon substrate can also be effectively reduced.

In the present disclosure, it is more preferred that a hydrogenated intrinsic amorphous silicon (i a-Si:H) layer is used as the intrinsic amorphous silicon layer. This is because by entering the amorphous silicon due to a hydrogenation reaction, hydrogen can reduce a dangling bond state of the amorphous silicon and a localized energy state within an energy band gap.

However, when a hydrogenated intrinsic amorphous silicon (i a-Si:H) layer is used, a temperature of a subsequent processe is limited to 250°C or less and more preferably 200°C or less. This is because the hydrogen bonding inside amorphous silicon breaks at a process temperature exceeding 200°C.

Therefore, in a subsequent process, there is a restriction that, particularly, firing in a process of forming a metal grid electrode, should also be carried out at a low temperature. On the other hand, there is an additional advantage that since the temperature of a subsequent process is low, the risk of thermal damage can be reduced.

In addition, the first solar cell 110 of the present disclosure may also be implemented as a homojunction crystalline silicon solar cell. Specifically, the first solar cell 110 has an emitter layer 112 disposed on a second surface of a crystalline silicon substrate 111. In addition, the first solar cell 110 may further have a BSF layer 113 disposed on a first surface of the crystalline silicon substrate 111. That is, the first solar cell 110 may have a two-layer structure in which a silicon substrate 111 and an emitter layer 112 are sequentially stacked. In addition, the first solar cell 110 may also have a three-layer structure in which a BSF layer 113, a silicon substrate 111, and an emitter layer 112 are sequentially stacked.

Here, since a layer doped with impurities of a different conductivity type from that of the crystalline silicon substrate 111 is used as the emitter layer 112 and a layer doped with impurities of the same conductivity type as that of the crystalline silicon substrate 111 is used as the BSF layer 113, a homojunction crystalline silicon solar cell 110 can be realized.

For example, when the crystalline silicon substrate 111 is an n-type monocrystalline silicon substrate, a semiconductor layer doped with p-type impurities is used as the emitter layer 112 and a semiconductor layer doped with n-type impurities is used as the BSF layer 113. Here, the BSF layer 113 may be an n+-type semiconductor layer which is doped at a higher concentration than the concentration of the n-type impurities used for doping the crystalline silicon substrate 111.

Here, the crystalline silicon substrate 111 of the first solar cell 110 has, in at least one of first and second surfaces thereof, a textured structure having valley and peak shapes. When such a textured structure is applied to a first surface of the crystalline silicon substrate 111, a BSF layer 113 subsequently disposed on the first surface of the crystalline silicon substrate 111 also acquires the textured structure. In addition, when a textured structure is applied to a second surface of the crystalline silicon substrate 111, an emitter layer 112, a inter-layer 114, and a second solar cell 120 which are sequentially provided on the second surface of the crystalline silicon substrate 111 also acquire the textured structure.

Since light having a long wavelength incident on the tandem solar cell is thus transmitted through the second solar cell 120 and enters the first solar cell 110 in an oblique direction, the reflectance at an interface between the inter-layer 114 and the first solar cell 110 can be reduced. In addition, since light having a long wavelength travels along an obliquely directed path in the first solar cell 110, there is an increase in a path of light, and therefore, a utilization rate of the light having a long wavelength can be improved in the first solar cell 110.

Meanwhile, conventionally, the formation of a perovskite absorption layer, which is a core component of a second solar cell, is mainly accomplished through a so-called solution process such as inkjet printing, gravure printing, spray coating, doctor-blade coating, bar coating, gravure coating, brush painting, slot-die coating, or the like. Such a solution process has advantages in that a light absorption layer constituting a photoactivation layer can be formed through very simple, easy, and inexpensive processes of applying and drying a solution. In addition, the solution process also has the advantage that a light absorption having coarse crystal grains can be formed, and, particularly, excellent conductivity for both electrons and holes is attained because spontaneous crystallization occurs due to the drying of an applied solution.

As can be understood from the term "solution process" itself, in a solution process, following the application of a solution to a substrate having a texture consisting of irregularities as in the present disclosure, the film is planarized due to leveling characteristics thereof. In this case, since the path of the light transmitted through the first electrode 130 is shortened and reflectance is increased, there is a high possibility that solar cell efficiency may be lowered.

Therefore, in order to form a structure in which upper layers conform to the textured structure, attempts have been made to form a perovskite absorption layer by a physical deposition method or a chemical deposition method. In both of these deposition methods, it is required that a porous perovskite precursor layer is formed.

However, in order to form a porous layer, before particles which have been deposited reach a stable and dense position on a substrate, it is basically required that other subsequent particles being deposited from a deposition source reach the substrate.

In the case of a texture including valleys having a radius of curvature of several nanometers, there is a problem that it is difficult for a material to be deposited to reach and be deposited in the valleys through such a deposition mechanism. In addition, even by solution processes which are conventionally widely used, it is very difficult to allow a solution to enter into the valley portions having a microscopic radius of curvature as such.

Meanwhile, when the radii of curvature become microscopic, the peak portions as well as the valley portions of the texture having a microscopic radius of curvature cause other problems.

In general, when a tandem solar cell is to be constructed, it is required that a inter-layer (also referred to as a tunnel inter-layer or an intermediate layer) is formed in order to electrically connect different solar cells. As a material for forming such a inter-layer, a transparent conductive layer, or a silicon layer doped with an opposite conductivity type to that of the emitter layer, can generally be used.

Due to the nature of the material or component, the inter-layers are formed through a thin-film deposition process. In such a thin-film deposition process, when a textured substrate which is not flat is used as in the present disclosure and, particularly, when the radius of curvature of the peak portions is small, the peak portions which have a small radius of curvature not only have the slowest deposition but also the lowest deposition rate due to the capillary phenomenon, that is, the Gibbs-Thomson effect.

Moreover, when the thickness of the inter-layer is very small such as in the case of tunnel junctions, the inter-layer becomes thinner, or even further, no deposition layer is formed on the peak portions of a texture. In addition, when the peak portions have a very small radius of curvature, not only is the deposition of a perovskite film formed on the inter-layer unstable, but also the conversion of the perovskite film becomes unstable, and therefore, cell characteristics may be degraded.

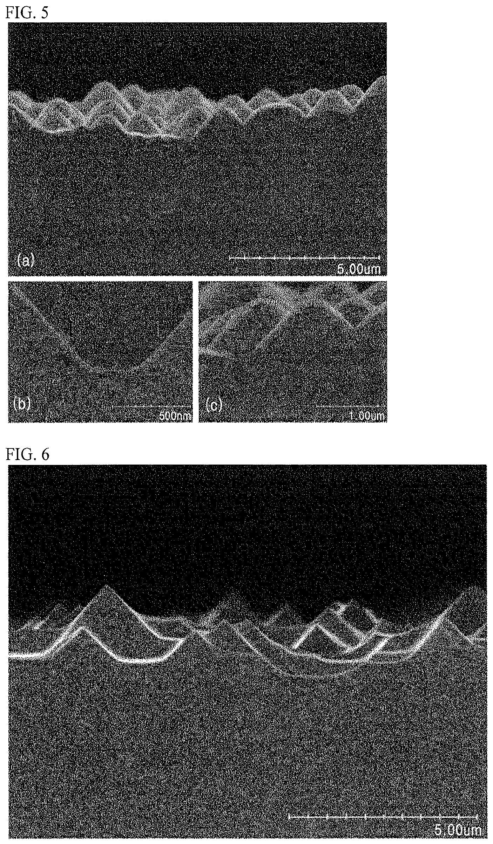

FIG. 4 is a cross-sectional electron microscope image illustrating a substrate on which a texture having peak portions and valley portions is formed, and FIG. 5 is a cross-sectional electron microscope image illustrating a substrate on which a texture is formed, wherein the texture has peak and valley portions on which a rounding process is performed and thus have a round shape.

As shown in FIG. 4, before the rounding process, the texture has peak and valley portions which are very sharp even in a microstructural sense, and the edges connecting a peak to a valley remain intact, maintaining a faceted structure. As a result of measuring the radii of curvature at some of the valley portions of FIG. 4, it was found that the texture has radii of curvature of about 15 to 20 nm before the rounding process.

Meanwhile, the edges are maintained at an angle of about 55 degrees relative to the surface of the substrate, assuming that the substrate is flat. This is attributed to the basic characteristics of a silicon (Si) substrate and of etching.

Monocrystalline silicon substrates are generally classified into {100} plane substrates, {111} plane substrates, and the like according to a growth plane. However, silicon has a diamond cubic crystal structure and a face-centered cubic lattice structure. In the case of such a face-centered cubic lattice, since a {111} plane is the most close-packed plane, the {111} planee is the most stable plane in terms of the binding energy of atoms.

Therefore, when a monocrystalline silicon substrate having a {100} plane is etched, since the bonding force between atoms is different for each silicon atomic plane, the fastest-etched palnes (i.e., planes with the weakest atomic bonding) are etched away first, and thus the slowest-etched planes (i.e., planes with the strongest atomic bonding) remain. For this reason, the etching of a monocrystalline material has an anisotropic nature which varies by direction.

In the texture of the present disclosure having peaks and valleys, the faces to which the diagonal lines of the pyramidal structures constituting the texture belong are all {111} planes, and the angles made by the {111} planes relative to the horizontal direction of the substrate are about 55 degrees in the case of a cubic lattice.

When a texture as shown in FIG. 4, which has not been subjected to a rounding process and has peaks and valleys with a small radius of curvature as well as faceted edges, is formed on a substrate, not only do the above-described problems arise, but also it is difficult for subsequent layers to be formed uniformly at each portion of the texture. As a result, the uniformity of tandem solar cell characteristics may not be ensured.

On the other hand, FIG. 5 illustrates a texture which has been rounded under isotropic etching conditions in the present disclosure. The substrate having a rounded texture as shown in FIG. 5 has several features unique to the present disclosure.

First of all, on average, in the rounded texture of the present disclosure, the absolute values of the radii of curvature of the valley portions are greater than or equal to the absolute values of the radii of curvature of the peak portions.

In general, even when isotropic etching is carried out, the peak portions which preferentially react with an etching component are preferentially etched over other portions. As a result, the radii of curvature of the peak portions become larger than the radii of curvature of valley portions, and when isotropic etching is continuously carried out for a sufficient period of time, the textured structure ultimately is removed due to the rapid etching of the peak portions. Therefore, only when the radii of curvature of valley portions are larger than the radii of curvature of peak portions as in the present disclosure, it is possible to uniformly form or convert a subsequent inter-layer and/or perovskite absorption layer as well as increasing the path of light by the textured structure of the substrate.

Here, it is preferred that the radii of curvature of the valley portions of the present disclosure are in a range of 0.05 to 50 $\mu$m. When the radii of curvature are smaller than 0.05 $\mu$m, the rounding cannot bring about the effect of allowing a subsequent inter-layer and/or perovskite absorption layer to be uniformly formed. On the other hand, when the radii of curvature exceed 50 $\mu$m, since the peak and valley portions are excessively etched away, the substrate is planarized. As a result, the texture cannot bring about its inherent effect of improving light absorption efficiency.

Meanwhile, after the rounding of the present disclosure as in FIG. 5, the radii of curvature of the valley portions are measured to be approximately 0.07 to 1.2 $\mu$m.

In addition to showing the radii of curvature, FIG. 5 clearly shows that the inclined surfaces connecting the valley portions to the peak portions in the texture form an angle of less than 55 degrees relative to the horizontal direction of the substrate.

As described above, the inclined surfaces in FIG. 4 are {111} planes which are chemically the most stable in monocrystalline silicon. However, in the present disclosure, since the inclined surfaces are also etched away to a certain degree due to the nature of isotropic etching, the above-described angle becomes less than 55 degrees which was measured before etching, as shown in FIG. 5. This enables the uniform deposition of a inter-layer and/or a perovskite absorption layer even at the inclined surfaces.

Meanwhile, rounded textures having different contours from that of FIG. 5 may also be formed.

FIG. 6 illustrates a texture according to another embodiment in which rounding has been accomplished by etching for about 10 minutes in an etching solution in which hydrofluoric acid and nitric acid are mixed in a ratio of 1:40.

It is illustrated that, in the texture of FIG. 6, the valley portions between peaks are etched away unlike in the texture of FIG. 5, resulting in the planarization of the valley portions. This illustrates that the inclined surfaces of the texture have also been uniformly etched away, resulting in a microstructure formed such that only the peaks are left in the texture. Such a texture on which a rounding process is continuously performed to the extent of planarization has a microstructure in which the average distance between valleys (or centers of flat portions) is larger than the average distance between peaks.

In particular, as a result of rounding the valley and peak portions of a texture by the etching, a thickness of a perovskite absorption layer formed at the valley portions and the peak portions differ by at most 10% in the present disclosure. In addition, since inclined surfaces are also etched away, the thickness of a perovskite absorption layer formed at the valley portions of the texture may differ from the thicknesses at the peak portions and the inclined surfaces of the texture by at most 10% in the present disclosure. Therefore, the present disclosure has the advantage that not only light efficiency is increased due to the texture, but also improved cell uniformity, which has only been attained in solar cells having flat interfaces, can be attained even in solar cells having textured interfaces.

In the present disclosure, the inter-layer 114 is disposed on the emitter layer 112 of the first solar cell 110, thereby serving to bond the first solar cell 110 and the second solar cell 120 together. Accordingly, the second solar cell 120 is electrically connected to the first solar cell 110 through the inter-layer 114.

In addition, the inter-layer 114 may be realized using a transparent conductive oxide (TCO), a carbonaceous conductive material, a metallic material, or a conductive polymer so that the light having a long wavelength transmitted through the second solar cell 120 can enter the first solar cell 110 disposed thereunder without transmission loss. In addition, the inter-layer 114 may be doped with an n-type or p-type material and used.

Here, as the transparent conductive oxide, indium tin oxide (ITO), zinc indium tin oxide (ZITO), zinc indium oxide (ZIO), zinc tin oxide (ZTO), gallium indium tin oxide (GITO), gallium indium oxide (GIO), gallium zinc oxide (GZO), aluminum-doped zinc oxide (AZO), fluorine tin oxide (FTO), ZnO, or the like may be used. As the carbonaceous conductive material, graphene, carbon nanotubes, or the like may be used, and as the metallic material, metal (Ag) nanowires or a metal thin film having a multilayer structure (e.g., Au/Ag/Cu/Mg/Mo/Ti) may be used. As the conductive polymer, polyaniline, polypyrrole, polythiophene, PEDOT:PSS, PTAA, Spiro-MeOTAD, PANI-CSA, or the like may be used.

In addition, the inter-layer 114 may also be realized as a multilayer structure in which silicon layers having different refractive indices are alternately stacked multiple times. Here, the multilayer structure may include layers having a lower refractive index and layers having a higher refractive index, which are alternately stacked. Accordingly, with respect to the inter-layer 114, light having a short wavelength can be reflected toward the second solar cell 120, and light having a long wavelength can be transmitted toward the first solar cell 110. In this case, selective collection of light can be realized in the perovskite/silicon tandem solar cell.

Here, since the structure in which layers having a lower refractive index and layers having a higher refractive index are alternately stacked is provided above/under the transparent conductive oxide layer or the n+-type silicon layer, selective reflection/transmission of the above-described light can be realized.

The second solar cell 120 of the present disclosure further includes an electron transport layer 121 and a hole transport layer 123 in addition to the perovskite absorption layer 122.

In this case, the electron transport layer 121 may be disposed under the perovskite absorption layer 122, and the hole transport layer 123 may be disposed above the perovskite absorption layer 122. Here, the positions of the electron transport layer 121 and the hole transport layer 123 may be switched as necessary.

A metal oxide may be used for the electron transport layer 121. Non-limiting examples of the metal oxides constituting the electron transport layer 121 include Ti oxide, Zn oxide, In oxide, Sn oxide, W oxide, Nb oxide, Mo oxide, Mg oxide, Zr oxide, Sr oxide, Yr oxide, La oxide, V oxide, Al oxide, Y oxide, Sc oxide, Sm oxide, Ga oxide, In oxide, SrTi oxide, and the like. More preferably, for the electron transport layer 121, at least one metal oxide selected from among ZnO, TiO2, SnO2, WO3, and TiSrO3 is used.

In addition, on the electron transport layer 121, a mesoporous layer 125 including a metal oxide that is the same as or different from the metal oxide of the electron transport layer 121 may be further provided. The mesoporous layer 125 assists in facilitating the transfer of electrons or holes, particularly, electrons, to the inter-layer 114 to be described below after hole-electron pairs generated in the perovskite absorption layer 122 are broken into holes and electrons. At the same time, the mesoporous layer 125 also serves to lengthen the path of light by forming a light-scattering structure.

The perovskite absorption layer 122 is a photoactive layer including a compound having a perovskite structure, wherein the perovskite structure may be represented as AMX3 (here, A refers to a monovalent organic ammonium cation or metal cation; M refers to a divalent metal cation; and X refers to a halogen anion). Non-limiting examples of compounds having a perovskite structure include $CH_3NH_3PbI_3$, $CH_3NH_3PbIxCl_3$-x, CH3 NH3 Pb Ix Br3-x, CH3 NH3 Pb Clx Br3-x, HC(NH2)2 Pb I3, HC(NH2)2 Pb Ix $Cl_3$-x, HC(NH2)2 Pb Ix Br3-x, HC(NH2)2 Pb Clx Br3-x, (CH3NH3) (HC(NH2)2)1-y Pb I3, (CH3NH3) (HC(NH2)2)1-y Pb Ix $Cl_3$-x, (CH3NH3) (HC(NH2)2)1-y Pb Ix Br3-x, (CH3NH3) (HC(NH2)2)1-y Pb Clx Br3-x (0≤x, y < 1), and the like. Here, the A of AMX3 may be partially doped with Cs in some cases.

The hole transport layer 123 may be realized using a conductive polymer. That is, as the conductive polymer, polyaniline, polypyrrole, polythiophene, poly(3,4-ethylenedioxythiophene)-poly(styrenesulfonate) (PEDOT:PSS), poly[bis(4-phenyl)(2,4,6-trimethylphenyl)amine] (PTAA), Spiro-MeOTAD, polyaniline-camphorsulfonic acid (PANI-CSA), or the like may be used. In this case, the hole transport layer 123 may further include an n-type or p-type dopant as necessary.

The second electrode 130 is disposed on the second solar cell 120. The second electrode 130 may be directly disposed, in the form of a grid, on the second solar cell 120. That is, the second electrode 130 may be formed of only a grid electrode layer 118 directly disposed on the second solar cell 120, without including a transparent electrode layer 116.

In addition, the second electrode 130 may include a transparent electrode layer 116 disposed on the second solar cell 120 and a grid electrode layer 118 disposed on the transparent electrode layer 116.

Here, the transparent electrode layer 116 is formed on the entire upper surface of the second solar cell 120, thereby serving to collect electrical charges generated in the second solar cell 120. Such a transparent electrode layer 116 may be realized using various transparent conductive materials. That is, as the transparent conductive material, the same material as the transparent conductive material of the inter-layer 114 may be used.

The grid electrode layer 118 is disposed on the transparent electrode layer 116, and is disposed on some parts of the transparent electrode layer 116.

Meanwhile, on the second surface of the crystalline silicon substrate 111, a buffer layer may be further disposed, but the addition thereof is not always required, and the buffer layer may be omitted as necessary. For the transmission of visible light, a transparent conductive compound or the like is preferable for the buffer layer. More specifically, as the transparent conductive oxide, ITO, ZITO, ZIO, ZTO, GITO, GIO, GZO, AZO, FTO, ZnO, or the like may be used.

The first electrode 140 is disposed on the first surface of the crystalline silicon substrate 111.

The first electrode 140 may be directly disposed, in the form of a grid, at the rear of the first solar cell 110. That is, the first electrode 140 may be formed of only a grid electrode layer 119 directly provided at the rear of the first solar cell 110, without including a transparent electrode layer 117.

In addition, the first electrode 140 may include a transparent electrode layer 117 disposed at the rear of the first solar cell 110 and a grid electrode layer 119 disposed on the transparent electrode layer 117.

Such a first electrode 140 is electrically connected to the BSF layer 113.

Accordingly, electrical charges generated in the first solar cell 110 are collected by the first electrode 140. In this case, it is preferred that the first electrode 140 is designed such that it is not disposed on the entire rear surface of the BSF layer 113 but only on some parts of the rear surface of the BSF layer 113 to allow sunlight to enter through the rear surface of the first solar cell 110.

In this case, the first electrode 140 is preferably disposed such that it occupies 1 to 30% of the total rear surface area of the BSF layer 113.

When the first electrode 140 occupies less than 1% of the area, there is a concern that the effect of the first electrode 140 collecting electrical charges generated in the first solar cell 110 may be insufficient. On the other hand, when the first electrode 140 occupies more than 30% of the area, since an excessively large area is occupied by the first electrode 140, there is a concern that the utilization rate of the light entering through the rear surface of the first solar cell 110 may be lowered.

Meanwhile, when the first solar cell of the present disclosure is a heterojunction silicon solar cell, the first electrode 140 and the second electrode 130 of the present disclosure may be simultaneously formed. This is because, when a hydrogenated intrinsic amorphous silicon (i a-Si:H) layer is used as the passivation layer, the process temperature is limited to 250°C or less to prevent the breaking of hydrogen bonds in the amorphous silicon. In this case, the first electrode 140 and the second electrode 130 may be formed through low-temperature firing at 250°C or less using a first electrode paste that does not contain glass frit.

On the other hand, when the first solar cell of the present disclosure is a homojunction silicon solar cell, the first electrode 140 and the second electrode 130 may be formed using two processes and not simultaneously, such that a higher-temperature firing process is carried out at 700°C or more to form the first electrode 140 and a lower-temperature firing process is carried out at 250°C or less using a second electrode paste not containing glass frit to form the second electrode 130.

In particular, it is preferable to form the second solar cell 120 and then the second electrode 130 after first forming the first electrode 140 by the high-temperature firing process. As the second solar cell 120 is exposed only to the firing process for forming the second electrode 130 which is carried out at a lower temperature of 250°C or less, since there is no concern that the second solar cell 120 is exposed to the firing process for forming the first electrode 140 which is carried out at a higher temperature of 700°C or more, the problem that the second solar cell 120 is degraded by high-temperature firing can be prevented in advance.

Hereinafter, a method of manufacturing the solar cell of FIGS. 2 and 3 having the texture of FIG. 5 or FIG. 6 will be described in detail with reference to exemplary embodiments.

Example: Method of manufacturing tandem solar cell

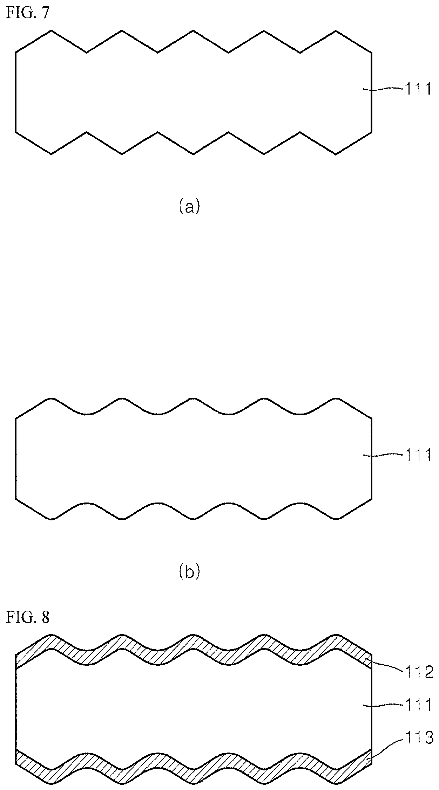

FIGS. 7 to 13 are cross-sectional views illustrating the processes of a method of manufacturing a tandem solar cell according to one embodiment of the present disclosure.

As shown in FIG. 7A, a texturing pattern is formed by planarizing the first and second surfaces of a crystalline silicon substrate 111 and then texturizing at least one of the first and second surfaces.

In this case, the textured structure may be introduced to the crystalline silicon substrate 111 using any one method among a wet chemical etching method, a dry chemical etching method, an electrochemical etching method, and a mechanical etching method, but the present disclosure is not limited thereto. For example, the textured structure may be introduced by etching at least one of the first and second surfaces of the crystalline silicon substrate 111 in a basic aqueous solution.

More specifically, first, an n-type monocrystalline silicon substrate that has a thickness of several hundreds of micrometers to several thousands of micrometers and has been sliced along a (100) plane is provided. Next, a surface of the substrate is etched at a temperature ranging from room temperature to 150°C using an aqueous solution prepared by adding an additive(s) such as an organic solvent, a phosphate, a reaction regulator and/or a surfactant to a 1 to 5 wt% aqueous sodium hydroxide (NaOH) solution or aqueous potassium hydroxide (KOH) solution.

The organic solvent may be at least any one of 2-methyl-2,4-pentanediol, propylene glycol, 2,2,4-trimethyl-1,3-pentanediol, 1,3-butanediol, 1,4-butanediol, 1,6-hexanediol, 2,2-dimethyl-1,3-propanediol, hydroquinone, 1,4-cyclohexanediol, and N-methyl prolyl.

In addition, the phosphate may be at least any one of $K_3PO_4$ and $K_2HPO_4$.

Through the etching, a texture having pyramidal irregularities is formed on a monocrystalline silicon substrate. Since monocrystalline silicon has a diamond cubic structure, a {111} plane is the most close-packed and chemically stable plane. Therefore, since etching in a sodium hydroxide solution is therefore the slowest in the {111} plane, after etching, anisotropic etching is found along the {111} plane of the silicon substrate. As a result, a texture having a depth of about 0.1 to 10 $\mu$m is uniformly formed on an entire surface of the silicon substrate.

Next, the texture is etched to form a rounded texture as shown in FIG. 7B. The rounding process may be carried out by any one of wet etching, sputtering etching, reactive ion etching, and vapor-phase etching.

In general, for wet etching of silicon substrates, HNO3/HF, KOH, tetramethylammonium hydroxide (TMAH), or other similar chemicals are used. Although the process of such wet etching is relatively easy and economical, wet etching has disadvantages in that it consumes a large amount of chemicals compared to dry etching and has a selective etching effect that is only effective for certain silicon substrate surfaces.

Meanwhile, dry etching, which may be exemplified by reactive ion etching, uses a chemically reactive plasma in order to remove a material deposited on a surface. Dry etching has advantages in that it can be applied to all types of silicon surfaces regardless of the crystallinity of the silicon substrates, does not require a mask, and consumes less gas compared to the amount of chemicals consumed in wet etching. However, due to including several steps, dry etching has a disadvantage in that the process thereof is somewhat complex and requires several types of working gases.

In the present disclosure, irrespective of whether it is wet etching or dry etching, any etching process can be applied as long as it allows for isotropic etching not anisotropic etching.

Accordingly, in one embodiment of the present disclosure for isotropic etching, the textured substrate was subjected to the rounding process using an etching solution in which hydrofluoric acid and nitric acid are mixed in a ratio of 1:(10 to 80), wherein the rounding process was carried out at a temperature not exceeding room temperature while adjusting the etching time. Specifically, it was possible to achieve the rounding process simply by immersing the textured substrate in the etching solution. In this case, when the proportion of hydrofluoric acid is increased and thus the ratio becomes greater than 1:10, that is, when the proportion of nitric acid is decreased, since etching becomes excessively slow, the effect of rounding cannot be easily exhibited. On the other hand, when the proportion of hydrofluoric acid is decreased and thus the ratio becomes less than 1:80, that is, when the proportion of nitric acid is increased, since the etching rate is increased, there is a problem that the radii of curvature of the valley portions are further increased.

Meanwhile, when necessary, pre-treatment of the textured substrate may be carried out before the rounding process. For example, in order to remove an oxide film from a surface of the substrate, the substrate may be immersed in an aqueous solution in which hydrofluoric acid and pure water are mixed in an arbitrary ratio. In addition, in order to remove aluminum, iron, magnesium, and the like degrading solar cell characteristics and to remove alkaline components, processes of oxidizing the surface using hydrochloric acid (HCl) and/or an aqueous solution containing hydrogen peroxide (H2O2) and then removing the oxidized film may be further carried out.

Next, an emitter layer 112 is formed on the second surface of the crystalline silicon substrate 111. After the emitter layer 112 is formed, a back surface field layer 113 may be further formed on the first surface of the crystalline silicon substrate 111 (see FIG. 8).

In the case of a heterojunction silicon solar cell, an amorphous intrinsic silicon (i a-Si:H) layer as a passivation layer is first deposited, by a plasma-enhanced chemical vapor deposition (PECVD) method using a silicon source material (SiH4, Si2H6, etc.) and hydrogen (H2), on a uniformly textured n-type silicon crystalline substrate. The PECVD method is particularly preferred as a method of manufacturing a heterojunction silicon solar cell because of the advantage that a process temperature can be lowered compared to common chemical vapor deposition (CVD) methods.

Next, a back surface field layer 113 doped with impurities of the same conductivity type as that of the silicon crystalline substrate are formed. Specifically, a PECVD process is used, and one or more types of gases selected from the group consisting of SiH4, Si2H6, SiHCl3, and SiH2Cl2 and H2 gas are used as reactants, and B2B6 or PH3 gas is used as a dopant gas. In this case, the temperature and pressure conditions of the PECVD process may be the same as the PECVD conditions for the amorphous intrinsic silicon layer.

When the first solar cell 110 is a heterojunction silicon solar cell, the first solar cell 110 can have a structure in which very thin amorphous intrinsic silicon (i a-Si:H) as a passivation layers are first formed on front and rear sides of an n-type crystalline silicon substrate, a p-type high-concentration amorphous silicon (p a-Si:H) layer as an emitter layer 112 is formed on the front side, and a high-concentration amorphous silicon (n+ a-Si:H) layer as a back surface field (hereinafter abbreviated as BSF) layer 113 is formed on the rear side.

On the other hand, in the case of a homojunction silicon solar cell, an emitter layer 112 and a BSF layer 113 may be formed through an ion implantation process. The emitter layer 112 is doped with boron as an impurity, and the BSF layer 113 is doped with phosphorous as an impurity. When the emitter layer 112 and the BSF layer 113 are formed through the ion implantation process, it is preferred that heat treatment is also performed at 700 to 1,200°C to activate the impurities. In addition, the emitter layer 112 and the BSF layer 113 may also be formed through a high-temperature diffusion process using BBr3, POCl3, or the like, instead of the ion implantation process.

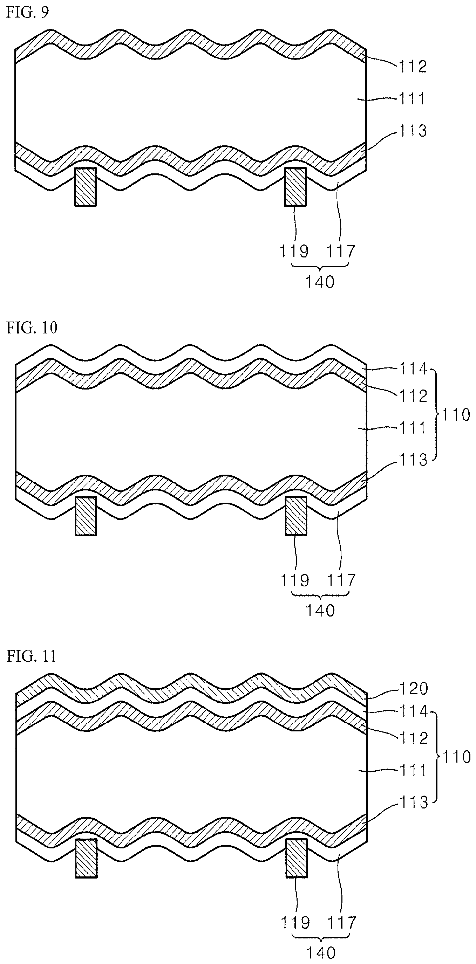

As shown in FIG. 9, the first electrode 140 is formed on the first surface of the crystalline silicon substrate 111.

In the case of a heterojunction silicon solar cell, for the above-described purpose of preventing the breaking of hydrogen bonds in the amorphous silicon, the process temperature for the first electrode 140 as well as the process temperature for the second electrode 130 is limited to 250°C or less. In this case, the first electrode 140 may be formed before the second electrode 130 is formed, or the first electrode 140 and the second electrode 130 may be simultaneously formed.

In the case of the first electrode 140, a transparent electrode layer 117 is first formed on the BSF layer 113. When a transparent conductive oxide such as ITO, ZITO, ZIO, ZTO, or the like is used as a material for the transparent electrode layer, the transparent electrode layer 117 may be deposited by sputtering.

After the transparent electrode layer 117 is formed, a grid electrode layer 119 is formed. Although, of course, it is also possible to form the grid electrode layer 119 directly on the BSF layer 113 without forming the transparent electrode layer 117, since the carrier mobility of amorphous silicon is rather low to collect carriers through a metal grid, it is more preferred that a transparent electrode layer 117 is formed.

In this case, the grid electrode layer 119 is formed by applying a second electrode paste on the transparent electrode layer 117 by a screen-printing method and carrying out heat treatment at a first temperature (which is the same as a second temperature).

The first electrode 140 may be formed by selectively applying a first electrode paste not containing glass frit and then carrying out low-temperature firing at a first temperature. Here, the first electrode paste may contain metal particles and an organic material which is a binder for low-temperature firing, and the first electrode paste does not contain glass frit. In particular, the first temperature may be 250°C or less and more specifically in a range of 100 to 200°C.

On the other hand, in the case of a homojunction silicon solar cell, the first electrode 140 and the second electrode 130 may be formed using two processes and not simultaneously such that a higher-temperature firing process is carried out at 700°C or more to form the first electrode 140 and a lower-temperature firing process is carried out at 250°C or less using a second electrode paste not containing glass frit to form the second electrode 130.

Here, the second electrode paste may be any one selected from among an Ag paste and an Ag/Al paste. In addition, the first electrode paste contains glass frit and an inorganic additive such as Ag particles, Ag/Al particles, or the like, and the first temperature may be 700°C or more and more specifically in a range of 700 to 1,100°C.

In this case, the first electrode 140 is preferably designed such that it is not disposed on an entire rear surface of the BSF layer 113 but only on some parts of the rear surface of the BSF layer 113 to allow sunlight to enter through the rear surface of the first solar cell 110. In particular, the first electrode 140 is preferably disposed such that it occupies 1 to 30% of the total rear surface area of the BSF layer 113.

As shown in FIG. 10, a inter-layer 114 is formed on the emitter layer 112.

In this case, as a material for the inter-layer 114, a transparent conductive oxide, a carbonaceous conductive material, a metallic material, or a conductive polymer may be used. In addition, the inter-layer may be doped with an n-type or p-type material and used.

More specifically, when a transparent conductive oxide such as ITO, ZITO, ZIO, ZTO, or the like is used for the inter-layer 114, the inter-layer 114 may be deposited by sputtering. Alternatively, instead of using a transparent conductive oxide, an n-type amorphous silicon layer may be deposited by PECVD to form the inter-layer 114.

The textured substrate of the present disclosure having rounded valley and peak portions enables the uniform deposition of a inter-layer 114 particularly at peak portions when the deposition is carried out through a thin-film deposition process.

In general, due to the capillary phenomenon, the smaller the positive curvature, the more thermodynamically unstable a material becomes, as in the following equation (the Gibbs-Thomson effect).

$$P^{\alpha} = P_{\infty} + (2\gamma)/r$$

$$p^{\beta} = p_{\infty} \left[ 1 + (2\gamma V_m^{\alpha}) / (RTr) \right]$$

Therefore, the smaller the radii of curvature of the peak portions (i.e., the sharper the peak portions become), the greater the tendency for particles deposited on the peak portions to move to other portions or to return to a vapor state. As a result, the thickness of the inter-layer 114 formed on a texture becomes smaller at peak portions than at other portions.

On the other hand, in a tandem solar cell of the present disclosure having a rounded texture, the inter-layer 114 is formed such that it has a uniform thickness at peak portions and other portions. It can be seen that this result directly proves the effect of rounding a texture in the present disclosure.

Next, a second solar cell 120 is formed on the inter-layer 114.

As shown in FIGS. 3 and 11, an operation of forming the second solar cell (perovskite solar cell) includes an operation of forming an electron transport layer 121 on the inter-layer 114, an operation of forming a perovskite absorption layer 122 on the electron transport layer 121, and an operation of forming a hole transport layer 123 on the perovskite absorption layer 122.

In addition, an operation of forming a mesoporous layer may be further included between the operation of forming an electron transport layer and the operation of forming a perovskite absorption layer. The electron transport layer 121 and the mesoporous layer 125 may be formed of the same metal oxide. For example, the electron transport layer 121 may be formed as a TiO2 layer having a thickness of 5 to 100 nm, and the mesoporous layer 125 may be formed as a TiO2 layer having a thickness of 500 nm or less.

Conventionally, perovskite absorption layers are mainly formed through a so-called solution process such as inkjet printing, gravure printing, spray coating, doctor-blade coating, bar coating, gravure coating, brush painting, slot-die coating, or the like. Such solution processes have advantages in that a light absorption constituting a photoactivation layer can be formed through very simple, easy, and inexpensive processes of applying and drying a solution. In addition, the solution processes also have the advantage that a light absorption having coarse crystal grains can be formed, and, particularly, excellent conductivity for both electrons and holes is attained because spontaneous crystallization occurs due to the drying of an applied solution.

However, as can be understood from the term "solution process" itself, in a solution process, following the application of a solution to a substrate having a textured structure consisting of irregularities as in the present disclosure, the film is planarized due to leveling characteristics thereof. In this case, since the path of the light transmitted through the second electrode 130 is shortened and reflectance is increased, there is a high possibility that solar cell efficiency may be lowered.

In the present disclosure, in order to completely transfer the contour of the textured substrate in forming the perovskite absorption layer, an electron transport layer or a mesoporous layer is first formed on the substrate having a rounded texture, and then a perovskite absorption layer that conforms to the textured surface is formed on the electron transport layer or mesoporous layer.

The perovskite absorption layer is formed by physical vapor deposition using sputtering or an electron beam or by chemical vapor deposition. In this case, although the perovskite absorption layer may be formed by any one of single-step deposition and sequential-step deposition, since it is difficult to form a uniform thin film by the single-step deposition, the sequential-step deposition is more preferred.

In the sequential-step deposition, the deposition of the first precursor layer is accomplished by forming a first precursor layer made of PbI2 on the textured electron transport layer 121 or mesoporous layer 125 by sputtering. Of course, besides PbI2, a component having a BX2 structure in which B includes one or more among $Pb^{2+}$, $Sn^{2+}$, $Cu^{2+}$, $Ca^{2+}$, $Sr^{2+}$, $Cd^{2+}$, $Ni^{2+}$, $Mn^{2+}$, $Fe^{2+}$, $Co^{2+}$, $Pd^{2+}$, $Ge^{2+}$, $Yb^{2+}$, and $Eu^{2+}$ and X includes one or more among $F^-$, $Cl^-$, $Br^-$, and $I^-$ may be used, and the component may be replaceable.

Specifically, when sputtering is used, the deposition of the first precursor layer is carried out under inert gas (Ar, He, or Ne) pressure conditions of 0.1 to 20 mTorr and electric power conditions of 100 to 300 W, using a target containing a PbI2 component. In this case, the temperature of a substrate is maintained within a range of room temperature to 100°C. In addition, since the component of the target is not a metal, RF sputtering which uses radio frequency is used as the sputtering method.

After the porous first precursor layer is formed, an operation of forming a second precursor layer on the porous first precursor layer is carried out.

In one embodiment of the present disclosure, a second precursor layer having a CH3 NH3 I composition is formed on the PbI2 layer. Of course, besides this component, the second precursor layer may also be formed of components which have an AX structure, wherein A includes one or more among a monovalent C1 -C20 alkyl group, an alkyl group substituted with an amine group, and an alkali metal, and X includes one or more among F⁻, Cl⁻, Br, and I⁻.

In the formation of the second precursor layer, processes such as a thermal evaporation method, sputtering, a CVD method, a spin coating method, a dip coating method, a spraying method, and the like may be used, and unlike in the formation of the first precursor layer, there is no particular limitation.

After the second precursor layer is formed, a post-thermal process is carried out to form a thin perovskite layer. The post-thermal process is carried out at a temperature ranging from room temperature to 200°C for at most about three hours. A lower limit of the post-thermal temperature is not particularly limited, and at a temperature exceeding 200°C, the second precursor layer may undergo thermal decomposition or a change in composition caused by thermal decomposition before even reacting with the first precursor layer to form a perovskite layer.

During the post-thermal process, the components of the second precursor layer penetrate into the first precursor layer which is a porous layer, to form a perovskite photoactive layer.

A final thickness of the perovskite absorption layer obtained by such a process becomes substantially the same as the thickness of the first precursor layer. This is because the final perovskite layer is formed by the penetration of the components of the second precursor layer into the porous first precursor layer.

The textured substrate of the present disclosure having rounded valley and peak portions has a synergistic effect in combination with the above-described method of forming a porous precursor layer.

Specifically, in order to form a porous precursor layer for a perovskite absorption layer, before materials which have been deposited reach a stable and dense deposition position, it is required that other subsequent materials being deposited from a deposition source onto a substrate reach the substrate. In other words, the deposition should be maintained at a relatively high speed in a general sense. Under such a deposition mechanism, there is a problem that it is difficult for a material to be deposited to reach and be deposited on a texture including valleys having a radius of curvature of several nanometers to several tens of nanometers.

Therefore, when a rounded texture is formed as in the present disclosure, a porous precursor layer can be uniformly deposited throughout the texture, including the valley portions, even at a high deposition rate. For this reason, the present disclosure has a very advantageous effect in achieving tandem solar cell uniformity.

After the perovskite absorption layer 122 is formed, a hole transport layer 123 is formed thereon. The hole transport layer 123 is a layer which allows the holes generated in the perovskite layer to be easily transferred to the second electrode 130, and should be able to ensure the ability to transmit visible light and conduct holes.

Meanwhile, in order to apply a solution process that can be used for the second precursor layer to also the hole transport layer 123, a polymer material is generally suitable as a material for the hole transport layer 123. In the present disclosure, a hole transport layer may be formed by carrying out spin coating for 40 to 50 seconds at a speed of 3000 to 5000 rpm using a polymer material such as PEDOT:PSS.

More specifically, in the method of forming a hole transport layer, a solution process such as a printing process may be applied after dissolving any one of PEDOT:PSS, poly(9-vinylcarbazole) (PVK), poly[(9,9-dioctylfluorenyl-2,7-diyl)-co-(4,4'(N-(4-sec-butylphenyl) diphenylamine))] (TFB), copper phthalocyanine (CuPc), N,N'-diphenyl-N,N'-bis(1-naphthyl)-1,1'-biphenyl-4,4'-diamine (a-NPD), and N,N'-bis-(3-methylphenyl)-N,N'-bis-phenyl(1,1'-biphenyl)-4,4'-diamine (TPD) into a liquid phase.

The hole transport layer 123 may include a monomer or polymer hole transport material or a metal oxide besides the above-described components. In addition, besides the above-described solution process, a solution process such as a dip coating method, a spraying method, or the like or even a deposition process such as a thermal evaporation method, a sputtering method, or the like may also be applied.

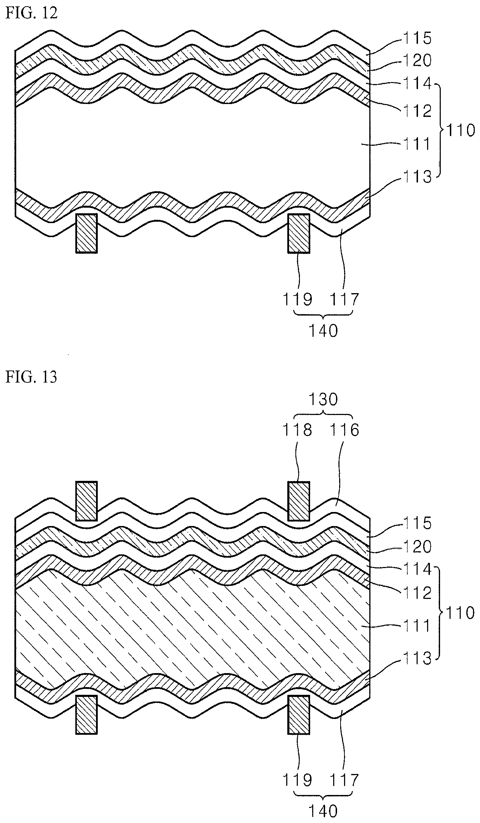

As shown in FIG. 12, after the hole transport layer 123 is formed, a buffer layer 115 may be formed as necessary. It is basically required that the buffer layer has the ability to transmit visible light while being able to protect the perovskite layer thereunder.

For the transmission of visible light, a transparent conductive compound or the like is preferable for the buffer layer 115. More specifically, as the transparent conductive oxide, ITO, ZITO, ZIO, ZTO, GITO, GIO, GZO, AZO, FTO, ZnO, or the like may be used.

A second electrode 130 is formed on the buffer layer 115 or the hole transport layer 123. Here, the second electrode 130 may include a transparent electrode layer 116 disposed on the second solar cell 120 and a grid electrode layer 118 disposed on the transparent electrode layer 116 (see FIG. 13).

Here, the transparent electrode layer 116 is formed on the entire upper surface of the second solar cell 120, thereby serving to collect electrical charges generated in the second solar cell 120. Such a transparent electrode layer 116 may be realized using various transparent conductive materials. That is, as the transparent conductive material, the same material as the transparent conductive material of the inter-layer 114 may be used.

The grid electrode layer 118 is disposed on the transparent electrode layer 116, and is disposed on some parts of the transparent electrode layer 116.

In this case, the second electrode 130 may be formed by selectively applying a second electrode paste not containing glass frit and then carrying out low-temperature firing at a second temperature. Such a second electrode paste may contain metal particles and an organic material which is a binder for low-temperature firing, and the second electrode paste does not contain glass frit. In particular, the second temperature may be 250°C or less and more specifically in a range of 100 to 200°C.

As described above, in the case of a heterojunction silicon solar cell, the first electrode 140 may be simultaneously formed with the second electrode 130 during the formation of the second electrode 130, or the second electrode 130 may be formed after the first electrode 140 and then the second solar cell are formed. In addition, in the case of a heterojunction silicon solar cell, both the first electrode 140 and the second electrode 130 are formed by a firing process carried out at a lower temperature of 250°C or less.

On the other hand, in the case of a homojunction silicon solar cell, first and second electrodes should be formed separately through a firing process which is carried out at a higher temperature of 700°C or more and in which the first electrode 140 is formed and a firing process which follows the formation of a second solar cell 120 and is carried out at a lower temperature of 250°C or less and in which the second electrode 130 is formed. This is to prevent in advance the problem that the second solar cell 120 is degraded by high-temperature firing.

As described above, in the present disclosure, since a substrate having a textured structure that has been rounded is used, it is possible to form a conformal inter-layer and a conformal perovskite absorption layer while suppressing the formation of a nonuniform inter-layer and a perovskite absorption layer.

Therefore, in a tandem solar cell of the present disclosure, since it is possible to improve cell reliability by securing uniformity in the deposition and conversion of a perovskite film and preventing short circuits, reduce the reflectance of light, and increase the path of light at the same time, cell characteristics can be improved.

Therefore, in the above-described method of manufacturing a tandem solar cell according to one embodiment of the present disclosure, after a texture having valleys and peaks is formed, the texture is rounded by isotropic etching, and a inter-layer and a porous perovskite precursor layer are formed on the texture. Through this, the method of manufacturing a tandem solar cell according to one embodiment of the present disclosure enables the formation of a conformal inter-layer and a conformal perovskite absorption layer that have a uniform thickness while thoroughly mirroring the contour of a substrate having a textured structure that has been rounded.

While the present disclosure has been described above, it is apparent that the invention is not limited to the embodiments disclosed herein and that various modifications may be made by those skilled in the art within the scope of the technical idea of the invention. In addition, although the effects of the configurations of the invention are not explicitly described in the description of the embodiments of the invention, it is apparent that the effects predictable by the configurations should also be recognized.

## Claims

1. A tandem solar cell comprising:

   a substrate (111) on which a rounded texture is formed; and
   a perovskite absorption layer (122) formed on the substrate (111),
   wherein the rounded texture comprises peak portions, and valley portions of the rounded texture are planarized.

2. The tandem solar cell of claim 1, wherein a radius of curvature of the valley portion has a different value from a radius of curvature of the peak portion.

3. The tandem solar cell of claim 2, wherein an absolute value of the radius of curvature of the valley portion is greater than or equal to an absolute value of the radius of curvature of the peak portion.

4. The tandem solar cell of claim 2 or claim 3, wherein the radius of curvature of the valley portion is in a range of 0.05 $\mu$m to 50 $\mu$m.

5. The tandem solar cell of claim 1, wherein an inclined surface connecting the valley portion to the peak portion forms an angle of less than 55 degrees relative to a planar direction of the substrate (111).

6. The tandem solar cell of claim 1, wherein, in the rounded texture, an average distance between valleys or between centers of flat portions is larger than an average distance between peaks.

7. The tandem solar cell of claim 5, wherein a thickness of the perovskite absorption layer (122) formed at the valley portion of the rounded texture differs from thicknesses at the peak portion and the inclined surface thereof by at most 10%.

8. A method of manufacturing a tandem solar cell, the method comprising:

   forming a texture on a substrate (111);
   performing a rounding process on valley portions and peak portions of the texture, such that the valley portions are planarized and that the peak portions are left; and
   forming a perovskite absorption layer (122) on the substrate (111).

9. The method of claim 8, wherein the texture is formed by anisotropic etching.

10. The method of claim 8, wherein the rounding process is isotropic etching that is carried out by any one of wet etching, sputtering etching, reactive ion etching, and vapor-phase etching.

11. The method of claim 10, wherein the rounding process is etching carried out using an etching solution in which hydrofluoric acid and nitric acid are mixed in a ratio of 1:(10 to 80).

12. The method of claim 8 further comprising forming a inter-layer before the forming of the perovskite absorption layer (122).

13. The method of claim 8, wherein the perovskite absorption layer (122) is formed by physical vapor deposition or chemical vapor deposition.

14. The method of claim 13, wherein the perovskite absorption layer (122) is formed through a porous precursor layer.

FIG. 1

FIG. 2

FIG. 3

FIG. 4

FIG. 5

FIG. 6

FIG. 7

(a)

(b)

FIG. 8

FIG. 9

112
111
113

119 117
140

FIG. 10

114
112
111
113
110

119 117
140

FIG. 11

120
114
112
111
113
110

119 117
140

FIG. 12

FIG. 13